# EUROPÄISCHE PATENTANMELDUNG

(11) **EP 2 009 970 A2**
(43) Veröffentlichungstag der Anmeldung: **31.12.2008**
(21) Anmeldenummer: 08011513.2
(22) Anmeldetag: 25.06.2008
(51) Int. Cl.: H05K 3/24, H05K 1/11

(54) **Verfahren zur Herstellung einer elektisch leitfähigen Struktur**

(30) Priorität: 29.06.2007 DE 102007030414
(71) Anmelder: Leonhard Kurz Stiftung & Co. KG, 90763 Fürth (DE)
(72) Erfinder: Lehnberger, Walter, 91757 Treuchtlingen (DE); Rohm, Michael, 90768 Fürth (DE)
(74) Vertreter: Zinsinger, Norbert

(57) **Zusammenfassung**

Die Erfindung betrifft ein Verfahren zur Herstellung einer elektrisch leitfähigen Struktur auf einem Trägersubstrat mit zumindestens zwei in einem Bereich (4) einer Breite b über die gesamte Breite b zwischen 500 µm und 1 µm beabstandeter Leiterbahnabschnitte (21, 22) sowie einen mehrschichtigen Folienkörper. Auf die Oberfläche des Trägersubstrats wird eine leitfähige Schicht (11) in Form der Leiterbahnabschnitte ausgebildet. Eine die elektrisch leitfähige Struktur bildende metallische Beschichtung wird durch Anlegen eines Stromflusses in einem Elektrolyt, das ein gelöstes Beschichtungsmetall enthält, auf der leitfähigen Schicht abgeschieden. Bei der Ausbildung der leitfähigen Schicht wird die leitfähige Schicht (11) zusätzlich in Form von beiseitig der Leiterbahnabschnitte (21, 22) angeordneten und konvex von dem gegenüberliegenden Leiterbahnabschnitt weggekrümmten Leiterbahnfortsätzen (23, 24, 25, 26) ausgebildet.

## Beschreibung

Die Erfindung betrifft ein Verfahren zur Herstellung einer elektrisch leitfähigen Struktur sowie einen mehrschichtigen Folienkörper mit einem Trägersubstrat, einer auf der Oberfläche des Trägersubstrats musterförmig ausgebildeten elektrisch leitfähigen Schicht und einer eine elektrisch leitfähige Struktur bildende, auf der leitfähigen Schicht galvanisch abgeschiedene metallische Beschichtung.

Die Herstellung von leitfähigen Strukturen auf einem Trägersubstrat insbesondere bei Produkten, die in hohen Stückzahlen hergestellt werden, hat möglichst kostengünstig zu erfolgen. So ist es bekannt, für die Herstellung einer leitfähigen Struktur eine Metallbeschichtung vollflächig auf ein Trägersubstrat aufzubringen und die Metallschicht anschließend durch einen Ätzprozess zu strukturieren. Weiter ist es bekannt, dass gewünschte Layout durch Drucken einer Leiterpaste zu realisieren. Diese Herstellungsverfahren verursachen jedoch aufgrund der vielen notwendigen Prozessschritte und aufgrund des großen Materialverbrauchs hohe Kosten.

Weiter wird in DE 102 54 927 A1 ein Verfahren zur Herstellung von leitfähigen Strukturen auf einem Träger beschrieben, bei dem zunächst die Oberfläche eines Trägers mit leitfähigen Partikeln bedeckt wird und anschließend eine Pasivierungsschicht auf die durch die leitfähigen Partikel gebildete Partikelschicht aufgebracht wird, die als Negativbild der leitfähigen Struktur ausgebildet ist. Anschließend wird der nicht von der Pasivierungsschicht gedeckte Bereich der leitfähigen Partikel galvanisch verstärkt, wodurch die leitfähigen Strukturen auf dem Träger ausgebildet werden.

Der Erfindung liegt nun die Aufgabe zugrunde, eine kostengünstige Herstellung einer elektrisch leitfähigen Struktur auf einem Trägersubstrat zu ermöglichen, welche enge benachbarte Leiterbahnabschnitte aufweist sowie einen kostengünstig herstellbaren Folienkörper mit einer solchen leitfähigen Struktur anzugeben.

Diese Aufgabe wird von einem Verfahren zur Herstellung einer elektrisch leitfähigen Struktur auf einem Trägersubstrat mit zumindestens zwei in einem Bereich einer Breite b über die gesamte Breite b zwischen 500 µm und 1 µm beabstandeter Leiterbahnabschnitte gelöst, bei dem auf die Oberfläche des Trägersubstrats eine leitfähige Schicht in Form der Leiterbahnabschnitte ausgebildet wird und eine die elektrisch leitfähige Struktur bildende metallische Beschichtung durch Anlegen eines Stromflusses in einem Elektrolyt, das ein gelöstes Beschichtungsmetall enthält, auf der leitfähigen Schicht abgeschieden wird, wobei bei der Ausbildung der leitfähigen Schicht die leitfähige Schicht zusätzlich in Form von beidseitig der Leiterbahnabschnitte angeordneten und konvex von dem gegenüberliegenden Leiterbahnabschnitt weggekrümmten Leiterbahnfortsätzen ausgebildet wird, so dass Feldlinienkonzentrationen des elektrischen Feldes bei der galvanischen Abscheidung des Beschichtungsmaterials in den Randbereichen der Leiterbahnabschnitte vermieden werden. Die Aufgabe wird weiter von einem mehrschichtigen Folienkörper gelöst, der ein Trägersubstrat, eine auf der Oberfläche des Trägersubstrats musterförmig ausgebildete leitfähige Schicht und eine, eine elektrisch leitfähige Struktur bildende, auf der leitfähigen Schicht durch Anlegen eines Stromflusses in einem Elektrolyt, dass ein gelöstes Beschichtungsmetall enthält, abgeschiedene metallische Beschichtung aufweist, wobei die elektrisch leitfähige Schicht in einem Bereich einer Breite b in Form von zwei über die gesamte Breite b zwischen 500 µm und 1 µm beabstandete Leiterbahnen ausgebildet ist und die leitfähige Schicht zusätzlich in Form von beidseitig der Leiterbahnabschnitte angeordneten und konvex von dem gegenüberliegenden Leiterbahnabschnitt weggekrümmten Leiterbahnfortsätzen vorgesehen ist.

Untersuchungen haben gezeigt, dass beim Abscheiden der metallischen Beschichtung unter Anlegen eines Stromflusses in eng benachbarten Leiterbahnabschnitten die metallische Beschichtung ungleich wächst. Insbesondere, wenn zur Erhöhung der Produktionsgeschwindigkeit die galvanische Abscheidung des Beschichtungsmaterials durch Erhöhung des Stromflusses in dem Elektrolyt erhöht wird, kommt es in Eckbereichen der Leiterbahnabschnitte, welche dem anderen Leiterbahnabschnitt gegenüberliegen, zunehmend zu einem verstärkten Anlagern des Beschichtungsmaterials, so dass die beiden Leiterbahnabschnitte in den Eckbereich zu einem Kurzschluss zusammenwachsen, das hergestellte Produkt so defekt und Ausschuss ist. Das Zusammenwachsen der beiden Leiterbahnabschnitte in den Eckbereich ist wohl auf die extrem hohe Feldliniendichte in diesen Bereichen zurückzuführen. Durch die Erfindung wird nun die Ausbildung dieser extrem hohen Feldlinienkonzentrationen des elektrischen Feldes in diesen Bereichen der Leiterbahnabschnitte durch das Vorsehen der zusätzlichen, konvex von dem gegenüberliegenden Leiterbahnabschnitt weggekrümmten Leiterbahnfortsätze vermieden. Hierdurch wird zwar einerseits der Materialverbrauch für die Herstellung des Produkts leicht erhöht, andererseits kann jedoch die Ausschussquote verringert und die Produktionsgeschwindigkeit durch Erhöhung des Stromflusses bei der galvanischen Beschichtung erhöht werden und so die Herstellungskosten gesenkt werden.

Vorteilhafte Weiterbildungen der Erfindung sind in den Unteransprüchen beschrieben. Gemäß eines bevorzugten Ausführungsbeispiels der Erfindung sind die sich gegenüberliegenden Flanken der beiden Leiterbahnabschnitte in dem Bereich über die gesamte Breite b im wesentlichen parallel zu einer gemeinsamen Geraden ausgerichtet. Unter im wesentlichen parallel wird hierbei verstanden, dass die gegenüberliegenden Flanken lediglich im Bereich der üblichen Fertigungstoleranz, d.h. nicht mehr als 100 µm von der gemeinsamen Geraden abweichen. Bevorzugt weichen die gegenüberliegenden Flanken hierbei nicht mehr als 10 % bezogen auf die Breite b von der gemeinsamen Geraden ab.

Die Leiterbahnabschnitte in dem Bereich sind bevorzugt über die gesamte Breite b weniger als 200 µm voneinander beabstandet, insbesondere zwischen 200 und 20 µm voneinander beabstandet. Gerade in diesem Abstandsbereich werden durch die Anwendung der Erfindung wesentliche Vorteile in Bezug auf die Senkung der Ausschussquote bzw. Erhöhung der Produktionsgeschwindigkeit erzielt.

Die Breite b beträgt vorzugsweise mehr als 400 µm, insbesondere mehr als 700 µm. Die Leiterbahnabschnitte werden vorzugsweise von einander gegenüberliegenden Leiterbahnenden gebildet. Die Leiterbahnabschnitte können hierbei von sich gegenüberliegenden Endbereichen einer beispielsweise schleifenförmig ausgeformten Leiterbahn, aber auch von den Endbereichen von zwei galvanisch getrennten Leiterbahnen gebildet sein. Die Leiterbahnenden besitzen hierbei bevorzugt eine Breite von 400 µm bis 5000 µm und größer.

Als besonders vorteilhaft hat sich die Anwendung der Erfindung auf Leiterbahnabschnitte erwiesen, die Kontaktbereiche für Schaltkreis-Chips bilden. Gemäß einer bevorzugten Ausführungsform der Erfindung ist die Leiterstruktur in Form einer Antenne ausgebildet und der Folienkörper weist einen Schaltkreis-Chip auf, der in dem Bereich angeordnet ist und elektrisch mit den beiden Leiterbahnabschnitten kontaktiert ist. Bevorzugt ist die Breite b hierbei größer als die Kantenlänge des Schaltkreis-Chips, insbesondere um 80 µm länger als die Kantenlänge des Schaltkreis-Chips.

Vorzugsweise werden die gekrümmten Leiterbahnfortsätze beidseitig jedes der beiden Leiterbahnabschnitte, unmittelbar an den jeweiligen Leiterbahnabschnitt anschließend, vorgesehen. Es ist jedoch auch möglich, dass die Leiterbahnfortsätze lediglich beidseitig eines der beiden Leiterbahnabschnitte vorgesehen werden, wobei hierbei jedoch die Gefahr des Zusammenwachsens der Randbereiche der Leiterbahnabschnitte erhöht wird.

Weiter ist es möglich, dass die dem jeweiligen anderen Leiterbahnabschnitt zugewandte Vorderkante der Leiterbahnfortsätze konvex gekrümmt ist, nicht jedoch die dem jeweiligen anderen Leiterbahnabschnitt abgewandte Hinterkante der Leiterbahnfortsätze. Unter konvex von dem gegenüberliegenden Leiterbahnabschnitt weggekrümmten Leiterbahnfortsätzen sind so Leiterbahnfortsätze zu verstehen, deren, dem jeweiligen anderen Leiterbahnabschnitt zugewandte Vorderkante entsprechend gekrümmt ist, unabhängig der Ausgestaltung der Hinterkante.

Der die Krümmung der Leiterbahnfortsätze definierende Krümmungsradius ist bevorzugt größer als die Breite b zu wählen. Weiter ist es auch möglich, dass sich der Krümmungskreis in den Punkten der die Vorderkante der Leiterbahnfortsätze beschreibenden Kurve entlang der Kurve ändert. In diesem Fall ist der Krümmungsradius des Krümmungskreises dieser Kurve in einem Grenzbereich oder im Grenzpunkt zu dem zugeordneten Leiterbahnabschnitt größer als die Breite b zu wählen. Vorzugsweise wird hierbei der Krümmungsradius in den Punkten eines Grenzbereichs einer Breite von 50 µm größer als die Breite b gewählt. Weiter werden die vorgehend beschriebenen Krümmungsradien bevorzugt nicht größer als das zweifache der Breite b gewählt. Untersuchungen haben gezeigt, dass eine derartige Ausformung der Leiterbahnfortsätze ein besonders effektives Verhältnis zwischen dem durch die Leiterbahnfortsätze bedingten Materialmehraufwand und dem erzielten Gewinn durch Erhöhung der Produktionsgeschwindigkeit/Verringerung der Ausschussquote erzielt werden kann.

Gemäß einem bevorzugten Ausführungsbeispiel der Erfindung sind die von dem zugeordneten Leiterbahnabschnitt abgewandten Enden der gegenüberliegenden konvex voneinander weggekrümmten Leiterbahnfortsätze mehr als 500 µm voneinander entfernt. Dies ist in vielen Fällen ausreichend, um das Zusammenwachsen der Leiterbahnabschnitte sicher zu verhindern.

Vorzugsweise wird weiter die Ausdehnung der Leiterbahnfortsätze in Richtung der Geraden, die durch die dem jeweiligen anderen Leiterbahnabschnitt zugewandte Vorderkante des zugeordneten Leiterbahnabschnitts definiert ist, mindestens halb so groß wie die Breite b, bevorzugt dreimal so groß wie die Breite b gewählt. Untersuchungen haben gezeigt, dass bei einer derartigen Ausformung der Leiterbahnabschnitte ein Zusammenwachsen der Leiterbahnabschnitte in den meisten Anwendungsfällen sicher verhindert werden kann.

Die Erfindung wird vorzugsweise für die Herstellung von RFID-Transponder (RFID = Radio Frequency Identification) eingesetzt, welche beispielsweise in Form von Chipkarten, aber auch von Warenetiketten zum Einsatz kommen können. Die Erfindung kann weiter jedoch für die Herstellung beliebiger anderer elektrisch leitfähiger Strukturen auf einem Trägersubstrat eingesetzt werden, bei denen elektrisch leitfähige Strukturen mit eng benachbarten Leiterbahnabschnitten kostengünstig zu fertigen sind.

Vorzugsweise wird die leitfähige Schicht durch Drucken eines leitfähigen Druckstoffes auf die Oberfläche des Trägersubstrats ausgebildet.

Vorzugsweise besteht die leitfähige Schicht aus einem leitfähigen Druckstoff.

Im folgenden wird die Erfindung anhand von mehreren Ausführungsbeispielen unter Zuhilfenahme der beiliegenden Zeichnungen beispielhaft erläutert.
- Fig. 1: zeigt eine schematisierte, nicht maßstabsgetreue Schnittdarstellung eines erfindungsgemäßen Folienkörpers.
- Fig. 2: zeigt eine Form einer leitfähigen Schicht für den Folienkörper nach Fig. 1 verdeutlichende Ansicht.
- Fig. 3: zeigt eine Form einer in dem erfindungsgemäßen Verfahren verwendbaren leitenden Schicht verdeutlichende Ansicht.

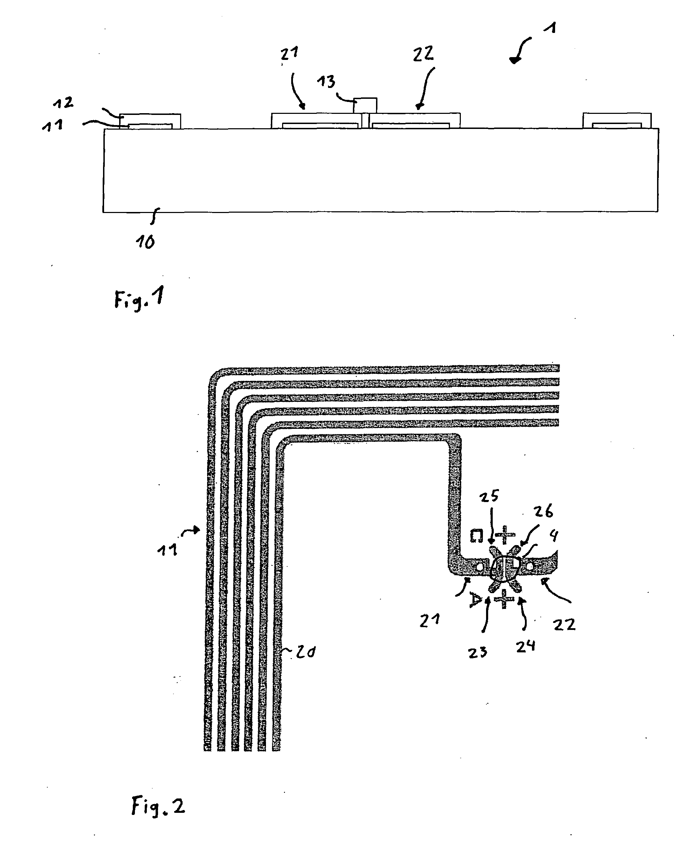

Fig. 1 zeigt einen mehrschichtigen Folienkörper 1 mit einem Trägersubstrat 10, einer leitfähigen Schicht 11, einer auf der leitfähigen Schicht 11 abgeschiedenen Beschichtung 12 und einem Schaltkreis-Chip 13.

Bei dem Trägersubstrat 10 handelt es sich vorzugsweise um eine Kunststofffolie, beispielsweise eine PET, PC oder BOPP-Folie einer Dicke von 12 bis 150 µm, vorzugsweise einer Dicke von 23 µm bis 75 µm. Weiter ist es auch möglich, dass das Trägersubstrat noch ein oder mehrere weitere Schichten umfasst, beispielsweise Dekorationsschichten zum Ausbilden optischer Effekte, elektrische Funktionsschichten, z.B. strukturierte Halbleiter-Polymer-Schichten, Schutzlackschichten, Haftvermittlungsschichten oder Abslöseschichten.

Auf das Trägersubstrat 10 wird nun in einem ersten Prozessschritt die leitfähige Schicht 11 ausgebildet, welche vorzugsweise eine Dicke von weniger als 1 µm besitzt. Hierzu wird vorzugsweise auf die Oberfläche des Trägersubstrats 10 ein leitfähiger Druckstoff musterförmig mittels eines Druckverfahrens, beispielsweise mittels Tiefdruck, Siebdruck oder Tampondruck aufgebracht. Als leitfähiger Druckstoff werden hierbei vorzugsweise in einem Dispersionsmittel gebundene Metallpartikel, beispielsweise bestehend aus Eisen, Kupfer, Nickel, Silber, Gold, Zinn oder Zink oder einer Legierung aus diesen Materialien oder platierte Metallpartikel, beispielsweise silberplatierte Kupferpartikel verwendet. Die Dispersion ist in ihren Hafteigenschaften so eingestellt, dass sie auf dem Trägersubstrat 10 haftet und von dem Druckwerkzeug rückstandsfrei ablösbar ist.

Bevorzugt wird als Druckstoff ein Silber enthaltender Druckstoff verwendet.

Weiter können auch sonstige elektrisch leitfähige, verdruckbare Stoffe eingesetzt werden, beispielsweise elektrisch leitfähige Tinten oder sonstige elektrisch leitfähige Partikel (beispielsweise Carbon Black) enthaltende Druckstoffe.

Weiter ist es auch möglich, dass zur Ausbildung der leitfähigen Schicht 11 auf dem Trägersubstrat 10 eine beispielsweise durch Hitze, Druck oder UV-Bestrahlung aktivierbare Kleberschicht musterförmig aufgebracht wird. In einem zweiten Schritt wird das Trägersubstrat 10 sodann mit leitfähigen Partikeln, die beispielsweise in Pulverform vorliegen können, bedeckt. Die Kleberschicht wird aktiviert und sodann die nicht durch die aktivierte Kleberschicht an dem Trägersubstrat anhaftenden leitfähigen Partikel entfernt, so dass sich ebenfalls wie in Fig. 1 gezeigt, die musterförmige, leitfähige Schicht 11 ausbildet. Weiter ist es auch möglich, dass die leitfähige Schicht 11 mittels eines Heißprägeprozesses durch bereichsweises Applizieren einer leitfähigen Transferlage eine Heißprägefolie ausgebildet wird und das Trägersubstrat 10 vollflächig mit einer elektrisch leitfähigen Schicht, beispielsweise durch Bedampfen, versehen wird, die dann bereichsweise zur Ausbildung der leitfähigen Schicht 11 wieder entfernt wird (mittels Ätzen, Ablation oder durch bereichsweise Aufbringen einer Pasiviersungsschicht bereichsweise für den nachfolgenden Galvanikprozess deaktiviert wird). Die leitfähige Schicht 11 wird hierbei durch den oben beschriebenen Prozess in der anhand Fig. 2 verdeutlichten, musterförmig strukturierten Form auf dem Trägersubstrat 10 ausgebildet.

Fig. 2 zeigt einen Ausschnitt einer Draufsicht auf die leitfähige Schicht 11. Die leitfähige Schicht 11 ist in Form von mehreren Leiterbahnen vorgesehen, welche die Form der herzustellenden, elektrisch leitfähigen Struktur besitzen. So zeigt Fig. 2 eine Leiterbahn 20, die in Form einer Antennenspule zur Ausbildung einer HF-Antenne eines RFID-Transponders ausgeformt ist. Ein Leiterbahnende 21 der Leiterbahn 20 ist in einem Bereich 4 beabstandet zu einem Leiterbahnende 22 einer anderen Leiterbahn angeordnet. Die beiden Leiterbahnenden sind über eine Breite von 400 bis 5000 µm oder größer nur ca. 200 bis 20 µm voneinander beabstandet vorgesehen. Zusätzlich zu dieser aus elektronischer Sicht funktionsnotwendigen Ausformung dieser Leiterbahnabschnitte (der Schaltkreis-Chip 13 ist in dem Bereich 4 angeordnet und über einen elektrisch leitfähigen Kleber mit dem Leiterbahnende 21 und mit dem Leiterbahnende 22 kontaktiert) sind Leiterbahnfortsätze 23, 24, 25 und 26 vorgesehen, die ein Zusammenwachsen der eng benachbart angeordenten Leiterbahnenden 21 und 22 während der nachfolgenden galvanischen Beschichtung verhindern. Die Leiterbahnabschnitte 23 und 25 sind beidseitig des Leiterbahnendes 21, unmittelbar an das Leiterbahnende 21 anschließend, angeordnet. Die Leiterbahnfortsätze 24 und 26 sind beidseitig des Leiterbahnendes 22, unmittelbar an das Leiterbahnende 22 anschließend, angeordnet. Die Leiterbahnfortsätze 23 und 25 sind konvex von dem gegenüberliegenden Leiterbahnende 22 weggekrümmt ausgeformt und schließen mit ihrer dem Leiterbahnende 22 gegenüberliegenden Vorderkante unmittelbar an die Vorderkante des Leiterbahnendes 23 an, so dass die Vorderkante des Leiterbahnendes 21 stetig in die Vorderkante der Leiterbahnfortsätze 23 und 25 übergeht. Der Übergang erfolgt so ohne Ausbildung von spitzen Winkeln und die die Vorderkante des Leiterbahnendes 21 und der Leiterbahnfortsätze 23 und 25 beschreibende gemeinsame Kurvenfunktion weist keine nicht-differenzierbaren Stellen auf. Das selbe gilt für das Leiterbahnende 22 und die an das Leiterbahnende 22 unmittelbar anschließenden Leiterbahnfortsätze 24 und 26.

Anschließend durchläuft das Trägersubstrat mit der darauf ausgebildeten elektrisch leitfähigen Schicht 11 ein Galvanikbad in dem durch Anlegen eines Stromflusses in einem Elektrolyt, das ein gelöstes Beschichtungsmetall enthält, die elektrisch leitfähige Schicht 12 auf der leitfähigen Schicht 11 abgeschieden wird. Als Beschichtungsmaterial wird hierbei vorzugsweise Kupfer, Chrom, Gold, Silber, Nickel oder Zink verwendet. Hierzu kann beispielsweise ein Bad folgender Zusammensetzung verwendet werden:

| Gewichtsanteile | |
|---|---|
| H₂O Dest. | 1000 |
| Cu SO₄ | 50 |
| H₂SO₄ (98 %ig) | 10 |
| L-Ascorbinsäure | 5 |

Die leitfähige Schicht 11 wird hierbei durch vorzugsweise stabförmige, in einer Kreisbewegung geführte Kontaktelektroden mit einer Stromquelle kontaktiert, so dass die leitfähige Schicht 11 eine Elektrode des in dem Galvanikbad anliegenden Stromflusses bildet und sich das Beschichtungsmetall auf der leitfähigen Schicht 11 abscheidet. Durch elektrolytische Verstärkung kann so eine Schichtdicke der elektrisch leitfähigen Strukturen von 1 bis etwa 50 µm erreicht werden. Wird mit nachstehenden Bedingungen gearbeitet, erhält man bei Verwendung von Kupfer eine Stärke von ca. 12 µm.
Abscheidespannung 10 V
Stromdichte ca. 12 A/dm²
Abscheidedauer ca. 1,5 bis 2 Minuten
Bad-Temperatur 50°C.

In diesem Zusammenhang ist darauf hinzuweisen, dass die Dicke der Metallschicht 12 um so größer wird, je höher die Stromdichte, die Abscheidespannung und/oder die Abscheidedauer ist.

Nach Verlassen des galvanischen Bades folgt eine Reinigung des Folienkörpers 1, beispielsweise durch eine neutralisierende Flüssigkeit und/oder destilliertes Wasser. Anschließend wird getrocknet.

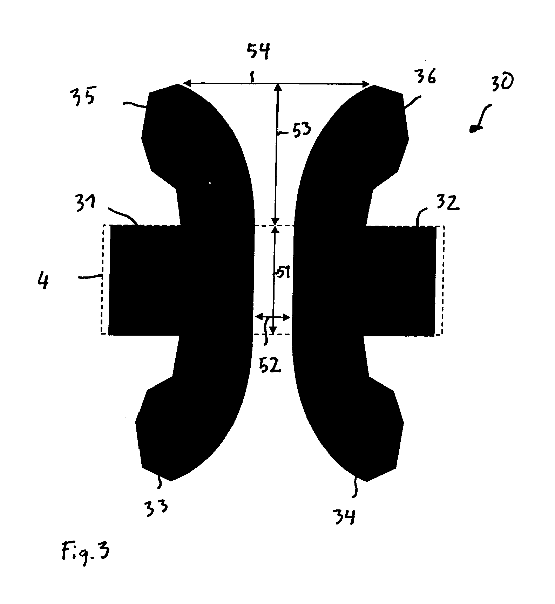

Anhand von Fig. 3 wird nun ein weiteres Ausführungsbeispiel für die Ausformung der leitfähigen Schicht 11 im Bereich zweier eng benachbarter Leiterbahnabschnitte beschrieben.

Fig. 3 zeigt einen Bereich 4 mit zwei Leiterbahnabschnitten 31 und 32. Die Leiterbahnabschnitte 31 und 32 bilden beispielsweise Leiterbahnenden zweier hier nicht gezeigter Leiterbahnen. Die einander zugewandten Stirnflächen der Leiterbahnabschnitte 31 und 32 sind in dem durch die Breite der Leiterbahnabschnitte 31 und 32 definierten Breite des Bereichs 4 im wesentlichen parallel zu einer gemeinsamen Geraden ausgerichtet. Die Breite 51 des Bereiches 4 ist hierbei bevorzugt in einem Bereich von 400 µm bis 800 µm gewählt, kann jedoch auch größer sein. Die Leiterbahnabschnitte 31 und 32 sind hierbei in einem Abstand 52 voneinander beabstandet, wobei der Abstand 52 zwischen 500 µm und 1 µm, bevorzugt weniger als 200 µm beträgt. Bei einer derart kleinen Beabstandung der einander zugewandten Flanken der Leiterbahnabschnitte 31 und 32 würden bei der nachfolgenden galvanischen Abscheidung des Beschichtungsmaterials die beiden Leiterbahnabschnitte 31 und 32 im Bereich der durch die gestrichelten Linien angedeuteten Grenzlinien des Bereichs 4 zusammenwachsen und so die leitfähige Struktur funktionsuntüchtig werden. Zur Vermeidung dieses Phänomens sind Leiterbahnfortsätze 33, 34, 35 und 36 vorgesehen, welche unmittelbar an die Leiterbahnabschnitte 31 bzw. 32 anschließt. Die Formgebung der Leiterbahnfortsätze 33, 34, 35 und 36 ist hierbei so gewählt, dass die dem gegenüberliegenden Leiterbahnabschnitt zugewandte Vorderkante konvex von dem gegenüberliegenden Leiterbahnabschnitt weggekrümmt ist. Die Leiterbahnfortsätze 33 bis 36 sind so von der durch die Vorderkanten der Leiterbahnabschnitte 31 und 32 weggekrümmt und besitzen so gegenüber den durch die gegenüberliegenden Flanken der Leiterbahnabschnitte 31 und 32 definierten gemeinsamen Geraden eine Krümmung. Der die einander gegenüberliegenden Vorderkanten der Leiterbahnfortsätze 33, 34, 35 und 36 beschreibende Krümmungsradius kann sich entlang der Vorderkanten ändern, wobei der Krümmungsradius bevorzugt größer als die Breite 51 gewählt ist.

Die Hinterkante der Leiterbahnfortsätze 33 bis 36 kann beliebig ausgeformt sein. Es ist so nicht notwendig, dass die Hinterkante konvex gekrümmt ist. Sie kann keine Krümmung aufweisen, oder auch konkav gekrümmt sein.

Die Leiterbahnfortsätze 35 und 36 weisen eine Ausdehnung 53 in Richtung der Geraden, die durch den dem jeweiligen anderen Leiterbahnabschnitt zugewandte Vorderkante des zugeordneten Leiterbahnabschnitts definiert ist, auf, welche mindestens der halben Breite 51, vorzugsweise mindestens dreimal der Breite 51 entspricht. Die Beabstandung 54 der Enden der gegenüberliegenden konvex weggekrümmten Leiterbahnfortsätze 35 und 36 sind vorzugsweise mehr als 500 µm voneinander entfernt. Unter den Enden der Leiterbahnfortsätze wird hierbei der von dem Endpunkt der Vorderkante der Leiterbahnfortsätze definierten Punkt verstanden, wie dies in Fig. 3 verdeutlicht ist.

## Patentansprüche

1. Verfahren zur Herstellung einer elektrisch leitfähigen Struktur auf einem Trägersubstrat (10) mit zumindestens zwei in einem Bereich (4) einer Breite b über die gesamte Breite b zwischen 500 µm und 1 µm beabstandeter Leiterbahnabschnitte (21, 22; 31, 32), wobei bei dem Verfahren auf der Oberfläche des Trägersubstrats (10) eine leitfähige Schicht (11) in Form der Leiterbahnabschnitte (21, 22; 31, 32) ausgebildet wird und eine die elektrisch leitfähige Struktur bildende metallische Beschichtung (12) durch Anlegen eines Stromflusses in einem Elektrolyt, das ein gelöstes Beschichtungsmetall enthält, auf der leitfähigen Schicht abgeschieden wird,
**dadurch gekennzeichnet,**
**dass** bei der Ausbildung der leitfähigen Schicht (11, 30) die leitfähige Schicht zusätzlich in Form von beidseitiger der Leiterbahnabschnitte (21, 22; 31, 32) angeordneten und konvex von dem gegenüberliegenden Leiterbahnabschnitt (22, 21; 32, 31) weggekrümmten Leiterbahnfortsätzen (23, 24, 25, 26) ausgebildet wird.

2. Verfahren nach Anspruch 1,
**dadurch gekennzeichnet,**
**dass** die sich gegenüberliegenden Flanken der beiden Leiterbahnabschnitte (21, 22; 31, 32) in dem Bereich (4) über die gesamte Breite b im wesentlichen parallel zu einer gemeinsamen Geraden ausgerichtet sind.

3. Verfahren nach einem der vorgehenden Ansprüche,
**dadurch gekennzeichnet,**
**dass** die Breite b größer als 400 µm, insbesondere größer als 700 µm ist.

4. Verfahren nach einem der vorgehenden Ansprüche,
**dadurch gekennzeichnet,**
**dass** die Leiterbahnabschnitte (21, 22; 31, 32) in dem Bereich (4) über die gesamte Breite b weniger als 300 µm voneinander beabstandet sind, insbesondere zwischen 200 µm und 20 µm voneinander beabstandet sind.

5. Verfahren nach einem der vorgehenden Ansprüche,
**dadurch gekennzeichnet,**
**dass** die gekrümmten Leiterbahnfortsätze (23, 24, 25, 26; 33, 34, 35, 36) beidseitig jedes der beiden Leiterbahnabschnitte unmittelbar an den jeweiligen Leiterbahnabschnitt anschließend vorgesehen werden.

6. Verfahren nach einem der vorgehenden Ansprüche,
**dadurch gekennzeichnet,**
**dass** die dem jeweiligen anderen Leiterbahnabschnitt zugewandte Vorderkante der Leiterbahnfortsätze konvex gekrümmt ist, nicht jedoch die dem jeweiligen anderen Leiterbahnabschnitt abgewandte Hinterkante der Leiterbahnfortsätze.

7. Verfahren nach einem der vorgehenden Ansprüche,
**dadurch gekennzeichnet,**
**dass** die Enden der gegenüberliegenden konvex voneinander weggekrümmten Leiterbahnfortsätze (33, 34; 35, 36) mehr als 500 µm voneinander entfernt sind.

8. Verfahren nach einem der vorgehenden Ansprüche,
**dadurch gekennzeichnet,**
**dass** der die Krümmung der Leiterbahnfortsätze definierende Krümmungsradius größer als die Breite b ist.

9. Verfahren nach einem der vorgehenden Ansprüche,
**dadurch gekennzeichnet,**
**dass** die Ausdehnung der Leiterbahnfortsätze in Richtung der Geraden, die durch die dem jeweiligen anderen Leiterbahnabschnitt zugewandte Vorderkante des zugeordneten Leiterbahnabschnitts definiert ist, mindestens der halben Breite b entspricht.

10. Mehrschichtiger Folienkörper (1) mit einem Trägersubstrat (10), einer auf der Oberfläche des Trägersubstrats musterförmig ausgebildeten leitfähigen Schicht (11) und einer eine elektrisch leitfähige Struktur bildende, auf der leitfähigen Schicht (11) galvanisch durch Anlegen eines Stromflusses in einem Elektrolyt, das ein größeres Beschichtungsmetall enthält, abgeschiedene metallische Beschichtung (12),
**dadurch gekennzeichnet,**
**dass** die elektrisch leitfähige Schicht (11) in einem Bereich einer Breite b in Form von zwei über die gesamte Breite b zwischen 500 µm und 1 µm beabstandeter Leiterbahnabschnitte (21, 22) ausgebildet ist und die leitfähige Schicht (11) zusätzlich in Form von beidseitig der Leiterbahnabschnitte (21, 22) angeordneten und konvex von dem gegenüberliegenden Leiterbahnabschnitt weggekrümmten Leiterbahnfortsätzen vorgesehen ist.

11. Mehrschichtiger Folienkörper (1) nach Anspruch 10,
**dadurch gekennzeichnet,**
**dass** das Trägersubstrat aus einer Kunststofffolie einer Dicke von 12 bis 150 µm besteht.

12. Mehrschichtiger Folienkörper (1) nach einem der Ansprüche 10 oder 11,
**dadurch gekennzeichnet,**
**dass** die metallische Beschichtung (12) eine Dicke von 1 bis 50 µm besitzt.

13. Mehrschichtiger Folienkörper (1) nach einem der Ansprüche 10 bis 12,
**dadurch gekennzeichnet,**
**dass** die beiden Leiterbahnabschnitte (21, 22) von einander gegenüberliegenden Leiterbahnenden gebildet sind.

14. Mehrschichtiger Folienkörper (1) nach einem der Ansprüche 10 bis 13,
**dadurch gekennzeichnet,**
**dass** die Leiterstruktur in Form einer Antenne ausgebildet ist.

15. Mehrschichtiger Folienkörper (1) nach einem der Ansprüche 10 bis 14,
**dadurch gekennzeichnet,**
**dass** der Folienkörper (1) einen Schaltkreis-Chip (13) aufweist und der Schaltkreis-Chip in dem Bereich (4) angeordnet und elektrisch mit den beiden Leiterbahnabschnitten (21, 22) kontaktiert ist.

16. Mehrschichtiger Folienkörper (1) nach Anspruch 15,
**dadurch gekennzeichnet,**
**dass** die Breite b größer als die Kantenlänge des Schaltkreis-Chips (13) ist.

17. Mehrschichtiger Folienkörper (1) nach Anspruch 16,
**dadurch gekennzeichnet,**
**dass** die Breite b um 80 µm größer als die Kantenlänge des Schaltkreis-Chips (13) ist.
